(19) Europäisches Patentamt
European Patent Office
Office européen des brevets

(11) Veröffentlichungsnummer: **0 296 112**
**A2**

(12) **EUROPÄISCHE PATENTANMELDUNG**

(21) Anmeldenummer: **88810388.4**

(22) Anmeldetag: **10.06.88**

(51) Int. Cl.4: **C 08 L 79/08**
C 08 G 73/12, C 08 J 5/24,
C 08 K 5/13, C 09 J 3/16

(30) Priorität: **18.06.87 CH 2303/87**

(43) Veröffentlichungstag der Anmeldung:
**21.12.88 Patentblatt 88/51**

(84) Benannte Vertragsstaaten:
**CH DE FR GB IT LI NL**

(71) Anmelder: **CIBA-GEIGY AG**
**Klybeckstrasse 141**
**CH-4002 Basel (CH)**

(72) Erfinder: **Schmid, Rolf, Dr.**
**Buhnenstock 14**
**CH-3150 Schwarzenburg (CH)**

**Stauffer, Werner**
**Av. Jean-Marie Musy 6**
**CH-1700 Fribourg (CH)**

(54) **Lagerstabile härtbare Mischungen.**

(57) Härtbare Mischungen, enthaltend

(i) ein Polyimid, welches im Molekül mindestens zwei Reste der Formel I

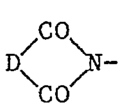

(I)

enthält, worin D einen zweiwertigen, eine C=C-Doppelbindung enthaltenden Rest bedeutet,

(ii) eine Verbindung der Formel II

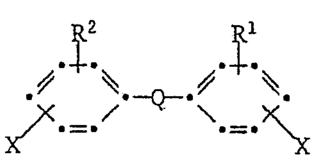

(II),

worin X für Wasserstoff oder OH steht, $R^1$ und $R^2$ unabhängig voneinander Allyl oder Propenyl sind und Q die direkte Bindung, $-(CH_2)_n-$, 2,2-Propyliden, -O-, -S-, -SO- oder $-SO_2-$bedeutet, wobei n 1 bis 6 ist, und

(iii) ein Dihydroxybenzol oder ein in 2- und/oder 6-Stellung sterisch gehindertes Phenol oder ein sekundäres aromatisches Amin.

Durch den Zusatz der Komponente (iii) wird die Klebrigkeit (tack) der härtbaren Mischungen während der Lagerung bei Raumtemperatur für längere Zeit erhalten. Dies ist besonders für Wickelharze für das Filament-Winding-Verfahren, für Matrixharze für Prepregs, für Pressmassen und Klebfilme von grosser Bedeutung.

EP 0 296 112 A2

**Beschreibung**

**Lagerstabile härtbare Mischungen**

Die vorliegende Erfindung betrifft lagerstabile heisshärtbare Mischungen und deren Verwendung, besonders als Wickelharz für das Filament-Winding-Verfahren, für Halbzeug mit Glas-, Kohle- oder Aramidfasern, als Pressmasse mit Kurzfasern/Whiskers, als Klebstoffe oder Filme für Hochtemperaturanwendungen oder zur Herstellung von Beschichtungen.

Aus der US-PS 4,100,140 sind heisshärtbare Mischungen aus Polyimiden mit C=C-Doppelbindungen, besonders Bismaleinimiden, Alkenylphenolen und/oder Alkenylphenolethern und gegebenenfalls Polymerisationskatalysatoren bekannt, die vor allem als Giessharze Anwendung finden. In der WO 81/02739 werden ähnliche Systeme beschrieben, in welchen als Vernetzungsmittel Divinylbenzol eingesetzt wird. Diese Mischungen eignen sich besonders als Matrixharze für die Herstellung von Verbundwerkstoffen. Da Divinylbenzol bekanntlich zur Homopolymerisation neigt, wird den Mischungen gegebenenfalls eine Oxidations-Inhibitor, z.B. Hydrochinon zugesetzt. Die Zugabe gewisser Phenole als Polymerisationsverhinderer zu Divinylbenzol ist z.B. in Ullmanns Encyklopädie der technischen Chemie, 22, 306 (1982) beschrieben.

Die Härtung von Bismaleinimiden mit Alkenylphenol oder Alkenylphenolethern ergibt Polymere mit hoher thermischer Beständigkeit, hoher Festigkeit und guter Zähigkeit. Daraus hergestellte Prepregs oder Klebfilme zeichnen sich durch gute Klebrigkeit (tack) aus. Diese Klebrigkeit ist für die Verarbeitung von ausserordentlicher Bedeutung, diese geht jedoch bei der Lagerung bei Raumtemperatur innerhalb weniger Tage weitgehend verloren. Deshalb müssen diese wertvollen Mischungen rasch verarbeitet werden oder kühl gelagert werden, um den Verlust an Klebrigkeit in Grenzen zu halten. Sowohl für den Harzhersteller wie für den Verbraucher wären hitzehärtbare Mischungen auf Basis von Bismaleinimiden und Diallylverbindungen, welche längere Zeit ohne Verlust der Klebrigkeit gelagert werden können, von grosser Bedeutung.

Die vorliegende Erfindung betrifft lagerstabile härtbare Mischungen, enthaltend

(i) ein Polyimid, welches im Molekül mindestens zwei Reste der Formel I

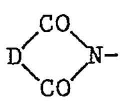 (I)

enthält, worin D einen zweiwertigen, eine C=C-Doppelbindung enthaltenden Rest bedeutet,

(ii) eine Verbindung der Formel II

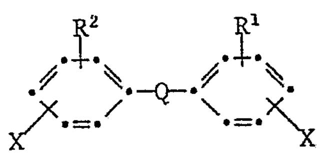 (II),

worin X für Wasserstoff oder OH steht, $R^1$ und $R^2$ unabhängig voneinander Allyl oder Propenyl sind und Q die direkte Bindung, $-(CH_2)_n-$, 2,2-Propyliden, -O-, -S-, -SO- oder $-SO_2-$bedeutet, wobei n 1 bis 6 ist, und

(iii) ein Dihydroxybenzol oder ein in 2- und/oder 6-Stellung sterisch gehindertes Phenol oder ein sekundäres aromatisches Amin.

Die Polyimide (i) sind bekannte Verbindungen und sind beispielsweise in der US-PS 4,100,140 beschrieben. Vorzugsweise handelt es sich dabei um Bismaleinimide der Formel III

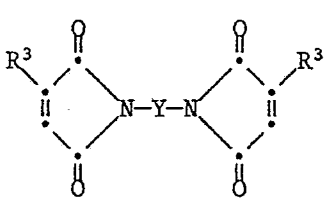 (III),

worin $R^3$ Wasserstoff oder Methyl bedeutet und Y eine Gruppe $-C_pH_{2p}-$mit p = 2-20, $-CH_2CH_2SCH_2CH_2-$, Phenylen, Naphthylen, Xylylen, Cyclopentylen, 1,5,5-Trimethylcyclohexylen-1,3; Cyclohexylen-1,4; 1,4-Bis(methylen)-cyclohexylen; der Rest des Bicyclohexylmethans oder eine Gruppe der Formel IV

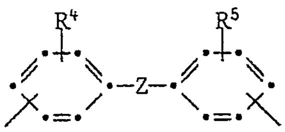

(IV)

ist, wobei $R^4$ und $R^5$ unabhängig voneinander Chlor, Brom, Methyl, Ethyl oder Wasserstoff bedeuten, und Z für Methylen, 2,2-Propyliden, -CO-, -O-, -S- oder $-SO_2-$ steht.

Besonders bevorzugte Bismaleinimide entsprechen der Formel III, worin $R^3$ Wasserstoff ist. Ausserdem bevorzugt sind Bismaleinimide der Formel III, worin Y Hexamethylen, Trimethylhexamethylen, 1,5,5-Trimethylcyclohexylen-1,3; der Rest des Bicyclohexylenmethans oder eine Gruppe der Formel IV ist, wobei X Methylen, 2,2-Propyliden oder -O- ist.

Natürlich können auch Mischungen von zwei und mehr verschiedenen Bismaleinimiden zum Einsatz kommen.

Beispiele für Bismaleinimide der Formel III sind:
N,N′-Ethylen-bis-maleinimid,
N,N′-Hexamethylen-bis-maleinimid,
N,N′-Trimethylhexylen-bis-maleinimid,
N,N′-m-Phenylen-bis-maleinimid,
N,N′-4,4′-Diphenylmethan-bis-maleinimid,
N,N′-4,4′-Diphenylether-bis-maleinimid,
N,N′-(1,5,5-Trimethylcyclohexylen-1,3)-bis-maleinimid (diese Verbindung ist neu und stellt auch einen Gegenstand der vorliegenden Erfindung dar),
N,N′-4,4′-Dicyclohexylmethan-bis-maleinimid,
N,N′-p-Xylylen-bis-maleinimid.

Die Herstellung der Polyimide (i) ist bekannt und erfolgt beispielsweise durch Umsetzung der ungesättigten Dicarbonsäureanhydride mit den entsprechenden Diaminen. Uebliche Methoden sind in der US-PS 3,010,290 oder der GB-PS 1,137,592 beschrieben.

Die Verbindungen der Formel II sind ebenfalls bekannte Verbindungen und sind z.B. in der US-PS 4,100,140 oder der EP-PS 14 816 beschrieben.

Bevorzugte Verbindungen der Formel II sind solche, worin X -OH bedeutet, besonders solche, die in 4,4′-Stellung sind.

$R^1$ und $R^2$ können unabhängig voneinander Allyl oder Propenyl bedeuten und sind in bevorzugten Verbindungen Allyl, insbesondere in 3,3′-Stellung.

In besonders bevorzugten Verbindungen der Formel II bedeutet Q Methylen, 2,2-Propyliden oder -O-.

Beispiele für Verbindungen der Formel II sind:
o,o′-Diallyl-bisphenol-A
o,o′-Dipropylen-bisphenol-A
4,4′-Dihydroxy-3,3′-diallyl-diphenyl
4,4′-Dihydroxy-3,3′-diallyl-diphenylen-methan
4,4′-Dihydroxy-3,3′-diallyl-diphenylen-ether.

Die Herstellung der Verbindungen der Formel II ist bekannt und erfolgt beispielsweise durch Umsetzung der entsprechenden unsubstituierten Diphenyle bzw. Phenole mit Allylchlorid, wobei die erhaltenen Produkte im Falle der Phenole anschliessend einer Claisen-Umlagerung unterworfen werden. Methoden dieser Art sind z.B. in der US-PS 4,100,140 und der EP-PS 14,816 beschrieben.

Die in 2- und/oder 6-Stellung sterisch gehinderten Phenole oder die sekundären aromatischen Amine, welche als Komponente (iii) zum Einsatz gelangen, werden in der Technik üblichersweise als Antioxidantien verwendet. Ueberraschenderweise wird durch deren Zusatz die Lagerfähigkeit, insbesondere bezüglich Klebrigkeit, von härtbaren Mischungen aus Polyimiden und Verbindungen der Formel II beträchtlich verbessert.

Anders als bei Divinylbenzol der WO 81/02739, bei welchem die Homopolymerisation des Vernetzungsmittels verhindert werden mus, neigen die Verbindungen der Formel II unter 100° C nicht zur Homopolymerisation. Es hat sich aber gezeigt, dass sich gerade Dihydroxybenzole und in 2-und/oder 6-Stellung disubstituierte ein- oder mehrkernige Phenole weitgehend unabhängig von ihrer spezifischen Struktur für die Lösung dieser Aufgabe eignen. Ausserdem haben sich auch sekundäre aromatische Amine, welche ebenfalls zu den Antioxidantien zählen, als geeignet erwiesen.

Beispiele für erfindungsgemäss zu verwendende Phenole sind:

1.0 Dihydroxybenzole, z.B. Resorcin oder Hydrochinon.

1.1. Alkylierte Monophenole, z.B. 2,6-Di-tert.butyl-4-methylphenol, 2-Tert.butyl-4,6-dimethylphenol, 2,6-Di-tert.butyl-4-ethylphenol, 2,6-Di-tert.butyl-4-n-butylphenol, 2,6-Di-tert.butyl-4-i-butylphenol, 2,6-Di-cyclopentyl-4-methylphenol, 2-(α-Methylcyclohexyl)-4,6-dimethyl-phenol, 2,6-Di-octadecyl-4-methylphenol, 2,4,6-Tri-cyclohexylphenol, 2,6-Di-tert.butyl-4-methoxymethylphenol, 2,6-Di-nonyl-4-methylphenol.

1.2. Alkylierte Hydrochinone, z.B. 2,6-Di-tert.butyl-4-methoxyphenol, 2,5-Di-tert.butyl-hydrochinon, 2,5-Di-tert.amyl-hydrochinon, 2,6-Di-phenyl-4-octadecyloxyphenol.

1.3. Hydroxylierte Thiodiphenylether, z.B. 2,2′-Thio-bis-(6-tert.-butyl-4-methylphenol), 2,2′-Thio-bis-(4-octylphenol), 4,4′-Thio-bis-(6-tert.butyl-3-methylphenol), 4,4′-Thio-bis-(6-tert.butyl-2-methyl-phenol).

1.4. Alkyliden-Bisphenole, z.B. 2,2′-Methylen-bis-(6-tert.butyl-4-methyl-phenol), 2,2′-Methylen-bis-(6-tert.butyl-4-ethylphenol), 2,2′-Methylen-bis-[4-methyl-6-(α-methylcyclohexyl)-phenol], 2,2′-Methylen-bis-(4-methyl-6-cyclohexylphenol), 2,2′-Methylen-bis-(6-nonyl-4-methylphenol), 2,2′-Methylen-bis-(4,6-di-tert.butylphenol), 2,2′-Ethyliden-bis-(4,6-di-tert.butylphenol), 2,2′-Ethyliden-bis-(6-tert.butyl-4-isobutylphenol), 2,2′-Methylen-bis-[6-(α-methylbenzyl)-4-nonylphenol], 2,2′-Methylen-bis- [6-(α,α-dimethylbenzyl)-4-nonylphenol], 4,4′-Methylen-bis-(2,6-di-tert.butylphenol), 4,4′-Methylen-bis-(6-tert.butyl-2-methylphenol), 1,1-Bis-(5-tert.butyl-4-hydroxy-2-methylphenyl)-butan, 2,6-Bis-(3-tert.butyl-5-methyl-2-hydroxybenzyl)-4-methylphenol, 1,1,3-Tris-(5-tert.butyl-4-hydroxy-2-methylphenyl)-butan, 1,1-Bis-(5-tert.butyl-4-hydroxy-2-methylphenyl)-3-n-dodecylmercaptobutan, Ethylenglycol-bis-[3,3-bis-(3′-tert.butyl-4′-hydroxyphenyl)-butyrat], Bis-(3-tert.butyl-4-hydroxy-5-methylphenyl)-dicyclopentadien, Bis-[2-(3′-tert.butyl-2′-hydroxy-5′-methyl-benzyl)-6-tert.butyl-4-methyl-phenyl]-terephthalat.

1.5 Benzylverbindungen, z.B. 1,3,5-Tris-(3,5-di-tert.butyl-4-hydroxybenzyl)-2,4,6-trimethylbenzol, Bis-(3,5-di-tert.butyl-4-hydroxybenzyl)-sulfid, 3,5-Di-tert.butyl-4-hydroxybenzyl-mercaptoessigsäureisooctylester, Bis-(4-tert.butyl-3-hydroxy-2,6-dimethylbenzyl)dithiolterephthalat, 1,3,5-Tris-(3,5-di-tert.butyl-4-hydroxybenzyl)-isocyanurat, 1,3,5-Tris-(4-tert.butyl-3-hydroxy-2,6-dimethylbenzyl)-isocyanurat, 3,5-Di-tert.butyl-4-hydroxybenzyl-phosphonsäure-dioctadecylester, Ca-Salz des 3,5-Di-tert.butyl-4-hydroxybenzyl-phosphonsäure-monoethylester, 1,3,5-Tris-(3,5-dicyclohexyl-4-hydroxybenzyl)isocyanurat.

1.6. Acylaminophenole, z.B. 4-Hydroxy-laurinsäureanilid, 4-Hydroxystearinsäureanilid, 2,4-Bis-(octylmercapto)-6-(3,5-di-tert.butyl-4-hydroxyanilino)-s-triazin, N-(3,5-di-tert.butyl-4-hydroxyphenyl)-carbaminsäureoctylester.

1.7. Ester der β-(3,5-Di-tert.butyl-4-hydroxyphenyl)-propionsäure mit ein- oder mehrwertigen Alkoholen, wie z.B. mit Methanol, Octadecanol, 1,6-Hexandiol, Neopentylglycol, Thiodiethylenglycol, Diethylenglycol, Triethylenglycol, Pentaerythrit, Tris-(hydroxyethyl)-isocyanurat, N,N′-Bis-(hydroxyethyl)-oxalsäurediamid.

1.8. Ester der β-(5-tert.Butyl-4-hydroxy-3-methylphenyl)-propionsäure mit ein- oder mehrwertigen Alkoholen, wie z.B. mit Methanol, Octadecanol, 1,6-Hexandiol, Neopentylglycol, Thiodiethylenglycol, Diethylenglycol, Triethylenglycol, Pentaerythrit, Tris-(hydroxy)ethyl-isocyanurat, N,N′-Bis-(hydroxyethyl)-oxalsäurediamid.

1.9. Ester der β-(3,5-Dicyclohexyl-4-hydroxyphenyl)-propionsäure mit ein-oder mehrwertigen Alkoholen, wie z.B. mit Methanol, Octadecanol, 1,6-Hexandiol, Neopentylglycol, Thiodiethylenglycol, Diethylenglycol, Triethylenglycol, Pentaerythrit, Tris-(hydroxy)ethyl-isocyanurat, N,N′-Bis-(hydroxyethyl)-oxalsäurediamid.

1.10. Amide der β-(3,5-Di-tert.butyl-4-hydroxyphenyl)-propionsäure, wie z.B. N,N′-Bis-(3,5-di-tert.butyl-4-hydroxyphenylpropionyl)-hexamethylendiamin, N,N′-Bis(3,5-di-tert.butyl-4-hydroxyphenylpropionyl)-trimethylendiamin, N,N′-Bis-(3,5-di-tert.butyl-4-hydroxyphenylpropionyl)-hydrazin.

Unter diesen Verbindungen sind besonders jene der Gruppen 1.3, 1.4, 1.5, 1.6 und 1.7 geeignet.

Insbesondere erwähnenswert sind 2,4-Bis-(n-octylmercapto)-6-(3,5-di-tert.butyl-4-hydroxyanilino)-s-triazin, β-(3,5-Di-tert.butyl-4-hydroxyphenyl)-propionsäureoctadecylester sowie Pentaerithrit-tetra-[3(3,5-di-tert.butyl-4-hydroxyphenyl)propionat].

Beispiele für erfindungsgemäss zu versendende Amine sind:

N,N′-Di-isopropyl-p-phenylendiamin
N,N′-Di-sec-butyl-p-phenylendiamin
N,N′-Bis-(1,4-dimethyl-pentyl)-p-phenylendiamin
N,N′-Bis(1-ethyl-3-methyl-pentyl)-p-phenylendiamin
N,N′-Bis(1-methyl-heptyl)-p-phenylendiamin
N,N′-Diphenyl-p-phenylendiamin
N,N′-Di-(naphthyl-2)-p-phenylendiamin
N-Isopropyl-N′-phenyl-p-phenylendiamin
N-(1,3-Dimethyl-butyl)-N′-phenyl-p-phenylendiamin
N-(1-Methyl-heptyl)-N′-phenyl-p-phenylendiamin
N-Cyclohexyl-N′-phenyl-p-phenylendiamin
N,N′-Dimethyl-N,N′-di-sec-butyl-p-phenylendiamin
Diphenylamin
4-Isopropoxy-diphenylamin
N-Phenyl-1-naphthylamin
N-Phenyl-2-naphthylamin
octyliertes Diphenylamin
4-n-Butylaminophenol
4-Butyrylamino-phenol
4-Nonanoylamino-phenol
4-Dodecanoylamino-phenol
4-Octadecanoylamino-phenol
Di-(4-methoxy-phenyl)-amin
2,6-Di-tert-butyl-4-dimethylamino-methyl-phenol
2,4′-Diamino-diphenylmethan

4,4′-Diamino-diphenylmethan
N,N,N′,N′-Tetramethyl-4,4′-diamino-diphenylmethan
1,2-Di-[(2-methyl-phenyl)-amino]-ethan
1,2-Di-(phenylamino)-propan
(o-Tolyl)-biguanid
Di-[4-(1′,3′-dimethyl-butyl)-phenyl)amin
tert-octyliertes N-Phenyl-1-naphthylamin
Gemisch aus mono- und dialkylierten tert-Butyl-/1,1,3,3-Tetramethylbutyldiphenylaminen.

Besonders bevorzugt wird Di[4,4′-(1,1,3,3-tetramethylbutyl)-phenyl]amin eingesetzt.

Selbstverständlich können auch Gemische der oben erwähnten Phenole und/oder Amine eingesetzt werden.

Die erfindungsgemäss zu verwendenden Phenole und Amine sind bekannte Verbindungen, vielfach handelsüblich und können, falls sie neu sind, nach an sich bekannten Methoden hergestellt werden.

Unter lagerstabilen härtbaren Mischungen gemäss vorliegender Erfindung werden insbesondere solche verstanden, welche pro Aequivalent des Polyimids (i) 0,3 bis 1,2 Aequivalente, vorzugsweise 0,5 bis 1,1 Aequivalente der Verbindung der Formel II und 0,05 bis 2 Gew.-%, vorzugsweise 0,1-0,3 Gew.-% bezogen auf die Summe (i) + (ii) der Komponente (iii) enthalten.

Die erfindungsgemässen Mischungen können auch weitere übliche Zusätze enthalten, z.B. Verdünner, Weichmacher, Streck-, Füll- und Verstärkungsmittel, wie beispielsweise Textilfasern, Glasfasern, Asbestfasern, Borfasern und Kohlenstoff-Fasern, mineralische Silikate, Metallpulver, z.B. Aluminiumpulver oder Eisenpulver, ferner Pigmente und Farbstoffe, wie Russ, Oxidfarben und Titandioxid, Flammschutzmittel, Thixotripiemittel, Verlaufmittel, Haftvermittler und Lichtschutzmittel.

Ferner ist auch der Zusatz von Thermoplasten bekannt und üblich. Als solche eignen sich insbesondere Polyimide, wie
- Polyimide mit Phenylindan-Einheiten, wie sie z.B. in der US-PS 3,856,752 und der EP-A 92,524 beschrieben sind,
- Homo- und Copolyimide aus mindestens einer aromatischen Tetracarbonsäure und mindestens einem aromatischen Amin, wie etwa in der EP-A 132,221 offenbart,
- Homo- und Copolyimide, wie sie in den EP-A 162,017, EP-A 107,621, EP-A 181,837 und EP-A 182,745 beschrieben sind, sowie
- Polyetherimide.

Werden Thermoplaste zugefügt, so vorzugsweise in Mengen von 2-20 Gewichtsteilen, besonders 3-12 Gewichtsteilen, bezogen auf 100 Gewichtsteile Harz/Härter-Gemische (i) + (ii). Dieser Zusatz kann vor allem bei der Filmherstellung von Vorteil sein.

Eine Uebersicht über übliche Zusätze von Thermoplasten findet sich in der EP-A 237,468.

Die Komponenten (i) und (ii) und der gegebenenfalls mitzuverwendete Reaktivverdünner ergeben beim Erhitzen vernetzte Produkte. Die Umsetzung erfolgt im allgemeinen bei Temperturen zwischen 50 und 300°C, besonders 100 und 250°C. Die Härtung kann auch in Gegenwart von Härtungskatalysatoren und -beschleunigern vorgenommen werden. Beispiele dafür sind in der US-PS 4,100,140 beschrieben. Im allgemeinen kann jedoch auf den Zusatz von Härtungskatalysatoren und -beschleunigern verzichtet werden.

Die erfindungsgemässen Gemische können vielseitig angewendet werden, z.B. als Laminier- oder Elektroharze, als Klebstoffe oder Klebefilme für Hochtemperaturanwendungen oder zur Herstellung von Beschichtungen. Insbesondere finden sie Anwendung zur Herstellung von kohlefaser- und glasfaserverstärkten Verbundwerkstoffen, besonders für deren Herstellung aus unidirektionalen Prepregs oder vorimprägnierten Rovings, z.B. für den Flugzeugbau, für Flugkörper und im Motorenbau, z.B. zur Herstellung von Gehäusen und Pleuelstangen, oder zur Herstellung von Laminaten (Prepregs), vor allem für gedruckte Schaltungen. Als Verarbeitungshilfsmittel für die Herstellung von Bändern oder Bahnen eignet sich z.B. der Zusatz von Phthalsäureestern und Cyanursäureestern, vor allem Phthalsäuredi-n-butyl-, -di-n-octyl- oder diallylester sowie Cyanursäuretriallylester.

Besonders hervorzuheben ist die Vewendbarkeit als Wickelharz für das Filament-Winding-Verfahren, als Matrixharz für Prepregs mit Glas-, Kohle-oder Aramidfasern, als Pressmasse mit Kurzfaser/Whiskers und als Klebfilme.

Gerade für diese Anwendungen besteht ein Bedarf an bei Raumtemperatur lagerstabilen härtbaren Mischungen. Es konnte nicht vorausgesehen werden, dass die Zeit bis zum Verschwinden der Klebrigkeit ("Out-life") durch den Zusatz der Komponente (iii) sehr stark verlängert werden könnte. Ueberraschenderweise wird auch die Härtungscharakteristik der Harze durch diese Komponente nicht negativ beeinflusst.

Beispiel 1:

26,8 g Diallylbisphenol-A (0,087 Mol) werden auf 140°C erwärmt, anschliessend unter Rühren 35,8 g 4,4′-Bismaleimidodiphenylmethan (0,1 Mol) zugegeben. Nach etwa 10-15 Min. ist das Bismaleinimid völlig aufgeschmolzen und die Mischung klar. Während 40 Min. wird die Mischung bei ca. 120°C entgast und anschliessend in Formen von 80 x 60 x 4 mm gegossen. In einem Ofen werden die Prüfkörper 1 h bei 180°C, 2 h bei 200°C und 6 h bei 250°C gehärtet.

Beispiel 2:

26,8 g Diallylbisphenol (0,087 Mol) und 0,125 g (0,2 % auf Harz + Härter) einer Komponente (iii) gemäss (Tabelle I) werden auf 140°C erwärmt und anschliessend 35,8 g (0,1 Mol) Bismaleinimid wie in Beispiel 1 zugegeben. Unter gleichen Bedingungen und Verarbeitung wie in Beispiel 1 werden Prüfkörper hergestellt. Aus Beispiel 1 und 2 werden folgende Resultate erhalten:

Tabelle I

| Stabilisator / Test | Bsp. 1 --- | Bsp. 2 (iii)a | Bsp. 2 (iii)b | Bsp. 2 (iii)c | Bsp. 2 (iii)d |
|---|---|---|---|---|---|
| Tack (1) | 1 | 2 | 3 | 3 | 3 |
| nach 10 Tagen bei 23°C | 0 | 1 | 3 | 3 | 3 |
| Tg TMA °C | 334 | 330 | 331 | 324 | 328 |
| Biegefestigk. MPa ISO 178 | 140 | 152 | 142 | 159 | 150 |
| Randdehnung % | 4,9 | 5,5 | 4,7 | 5,8 | 5,2 |

Tack (1) = Klebrigkeit des Matrix-Films 0: kein Tack
1,2,3: zunehmend besserer Tack, wobei der Index 3 unveränderter tack bedeutet.

(iii)a = Pentaerithrit-tetra-[3-(3,5-di-tert.butyl-4-hydroxyphenyl)-propionat]

(iii)b = β-(3,5-Di-tert.butyl-4-hydroxyphenyl)propionsäureoctadecylester

(iii)c = 2,4-Bis-(n-octylmercapto)-6-(3,5-di-tert.butyl-4-hydroxy-anilino)-s-triazin

(iii)d = Di-[4,4'-(1,1,3,3-tetramethylbutyl)phenyl]-amin

Beispiel 3:

39 g Polyimid auf Phenylindanbasis (Matrimid® 5218) werden in 150 g Methylenchlorid gelöst, 262 g Diallylbisphenol-A, 24,6 g Diallylphthalat (0,1 Mol) als Reaktivverdünner und 1,36 g 2,4-Bis-(n-octylmercapto)-6-(3,5-di-tert.butyl-4-hydroxyanilino)-s-triazin (= Komponente (iii)c) (0,2 % auf gesamte Mischung ohne $CH_2Cl_2$) zugegeben und unter Rühren gut vermischt. Das Methylenchlorid wird abdestilliert und die Mischung auf 140°C erwärmt. Anschliessend werden 358 g 4,4'-Bismaleimidodiphenylmethan während ca. 15-20 Min. gelöst. Ein Teil der erhaltenen Mischung wurde wie Beispiel 1 zu Prüfkörper verarbeitet der andere (als Film) für analytische Untersuchungen bereitgestellt.

Beispiel 4:

Wie Beispiel 3, aber ohne Triazin-Komponente, werden Prüfkörper und Matrixfilm hergestellt. Für Beispiel 3 und 4 werden folgende Resultate erhalten

Tabelle II

| System / Test | tel quel (Beispiel 4) | stabilisiert Beispiel 3 |
|---|---|---|
| Tg TMA °C | (289) 350 | (283) 348 |
| Biegefestigk. MPa | 149 | 156 |
| Randdehnung % | 4,4 | 4,8 |

Gelierzeit

Tabelle III

| System | tel quel | | | stabilisiert (Bsp. 3) | | |
|---|---|---|---|---|---|---|
| Test | vor Lagerung Min. | 14 Tage bei 23°C Min. | 38 Tage bei 23°C Min. | vor Lagerung Min. | 14 Tage bei 23°C Min. | 38 Tag bei 23°C Min. |
| Gelierzeit 120° | 335 | 220 | 170 | 540 | 550 | 540 |
| 140° | 105 | 75 | 55 | 170 | 185 | 170 |
| 160° | 48 | 31 | 20 | 68 | 70 | 70 |
| 180° | 20 | 14 | 8 | 28 | 29 | 28 |
| Tack | 3 | 1 | 0-1 | 3 | 3 | 1 |

Während der Lagerung eines Filmes bei Raumtemperatur wird die Gelierzeit stark reduziert. Die Verarbeitung eines Prepregs zu Formteilen wird erschwert oder verunmöglicht. Durch Zusatz von 0,2 % der Komponente (iii)c bleibt die Gelierzeit unverändert.

Beispiel 5:

26,8 g Diallylbisphenol-A (0,087 Mol) werden auf 140°C erwärmt, anschliessend unter Rühren 35,8 g 4,4'-Bismaleimidodiphenylmethan (0,1 Mol) zugegeben. Nach etwa 10-15 Min. ist das Bismaleinimid völlig aufgeschmolzen und die Mischung klar. Während 10 Min. wird die Mischung bei ca. 120°C entgast und anschliessend mit einem Stab-Takel ein Film auf siliconisiertem Papier hergestellt. An diesen so hergestellten Filmen wurde die Klebrigkeit am Anfang und nach 10 Tagen gemessen. Die Ziffern 0, 1, 2, 3 haben dabei die gleich bei Tabelle I angegebene Bedeutung.

Beispiele 6-16

Unter den gleichen in Beispiel 5 beschriebenen Bedingungen werden Filme hergestellt, welche zusätzlich die in der Tabelle IV angegebenen Mengen einer Komponente (iii) enthalten.

Tabelle IV

| Stabilisator gemäss Bsp. / Tack | 5 | 6 | 7 | 8 | 9 | 10 | 11 | 12 | 13 | 14 | 15 | 16 |
|---|---|---|---|---|---|---|---|---|---|---|---|---|
| | — | 0,5 % (iii)c | 0,5 % (iii)d | 0,2 % (iii)c + 94 % (iii)d | 0,2 % (iii)e | 0,2 % (iii)f | 0,2 % (iii)g | 0,2 % (iii)h | 0,2 % (iii)i | 0,2 % (iii)k | 0,2 % (iii)l | 0,2 % (iii)m |
| anfangs | 3 | 3 | 3 | 3 | 3 | 3 | 3 | 3 | 3 | 3 | 3 | 3 |
| nach 10 Tagen bei 23°C | 1 | 3 | 3 | 3 | 3 | 2 | 2 | 2 | 2 | 2 | 2 | 2 |

(iii)c = 2,4-Bis-(n-octylmercapto)-6-(3,5-di-tert.butyl-4-hydroxy-anilino)-s-triazin

(iii)d = Di-[4,4'-(1,1,3,3-tetramethylbutyl)phenyl]-amin

(iii)e = Hydrochinon

(iii)f = 1,8-Bis-[3-(3,5-di-tert.butyl-4-hydroxyphenyl)-propionyloxy]-3,6-dioxa-n-octan

(iii)g = 1,6-Bis-[3-(3,5-di-tert.butyl-4-hydroxyphenyl)-propionamido]-n-hexan

(iii)h = Calciumsalz des 3,5-Di-tert.butyl-4-hydroxybenzylphosphonsäure-monoethylesters

(iii)i = N,N'-Bis-(3,5-di-tert.butyl-4-hydroxyphenyl-propionyl)-hydrazin

(iii)k = 2,2'-Thio-bis-(4-methyl-6-tert.butylphenol)

(iii)l = 2,2'-Methylen-bis-(4-methyl-6-tert.butylphenol)

(iii)m = 1,3-Bis-(3,5-dicyclohexyl-4-hydroxybenzyl)-5-(3,5-di-tert.butyl-4-hydroxybenzyl)-isocyanurat

Die Resultate dieser Tabelle zeigen deutlich die starke verringerte Klebrigkeitsabnahme während der Lagerung.

## Patentansprüche

1. Lagerstabile härtbare Mischungen, enthaltend
   (i) ein Polyimid, welches im Molekül mindestens zwei Reste der Formel I

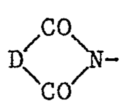 (I)

enthält, worin D einen zweiwertigen, eine C=C-Doppelbindung enthaltenden Rest bedeutet,
   (ii) eine Verbindung der Formel II

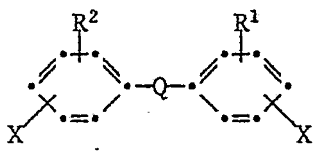

(II),

worin X für Wasserstoff oder OH steht, $R^1$ und $R^2$ unabhängig voneinander Allyl oder Propenyl sind und Q die direkte Bindung, $-(CH_2)_n-$, 2,2-Propyliden, -O-, -S-, -SO- oder $-SO_2-$bedeutet, wobei n 1 bis 6 ist, und

(iii) ein Dihydroxybenzol oder ein in 2- und/oder 6-Stellung sterisch gehindertes Phenol oder ein sekundäres aromatisches Amin.

2. Mischungen nach Anspruch 1, enthaltend ein Bismaleinimid der Formel III

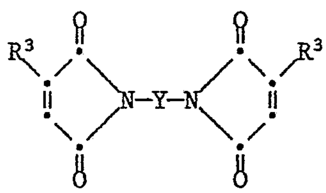

(III),

worin $R^3$ Wasserstoff oder Methyl bedeutet und Y eine Gruppe $-C_pH_{2p}-$mit $p = 2\text{-}20$, $-CH_2CH_2SCH_2CH_2-$, Phenylen, Naphthylen, Xylylen, Cyclopentylen, 1,5,5-Trimethylcyclohexylen-1,3; Cyclohexylen-1,4; 1,4-Bis(methylen)-cyclohexylen; der Rest des Bicyclohexylmethans oder eine Gruppe der Formel IV

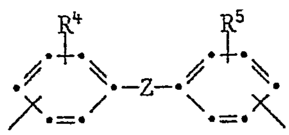

(IV)

ist, wobei $R^4$ und $R^5$ unabhängig voneinander Chlor, Brom, Methyl, Ethyl oder Wasserstoff bedeuten, und Z für Methylen, 2,2-Propyliden, -CO-, -O-, -S- oder $-SO_2-$ steht.

3. Mischungen nach Anspruch 2, enthaltend ein Bismaleinimid der Formel III, worin $R^3$ Wasserstoff ist.

4. Mischungen nach Anspruch 2, enthaltend ein Bismaleinimid der Formel III, worin Y Hexamethylen, Trimethylhexamethylen, 1,5,5-Trimethylcyclohexylen-1,3; der Rest des Bicyclohexylenmethans oder eine Gruppe der Formel IV ist, wobei X Methylen, 2,2-Propyliden oder -O-ist.

5. Mischungen nach Anspruch 1, enthaltend eine Verbindung der Formel II, worin X -OH bedeutet.

6. Mischungen nach Anspruch 1, enthaltend eine Verbindung der Formel II, worin $R^1$ und $R^2$ Allyl sind.

7. Mischungen nach Anspruch 1, enthaltend eine Verbindung der Formel II, worin Q Methylen, 2,2-Propyliden oder -O- ist.

8. Mischungen nach Anspruch 1, enthaltend als Komponente (iii) ein in 2-und/oder 6-Stellung sterisch gehindertes Phenol.

9. Mischungen nach Anspruch 1, enthaltend als Komponente (iii) ein sekundäres aromatisches Amin.

10. Mischungen nach Anspruch 8, enthaltend als Komponente (iii) 2,4-Bis-(n-octylmercapto)-6-(3,5-di-tert.butyl-4-hydroxyanilino)-s-triazin.

11. Mischungen nach Anspruch 9, enthaltend als Komponente (iii) Di-[4,4′-(1,1,3,3-tetramethylbutyl)phenyl]-amin.

12. Mischungen nach Anspruch 1, enthaltend zusätzlich einen Thermoplast.

13. Mischungen nach Anspruch 10, enthaltend ein Polyimid oder ein Polyetherimid.

14. Verwendung der Mischungen nach Anspruch 1 als Wickelharz für das Filament-Winding-Verfahren, als Matrixharz für Prepregs mit Glas-, Kohle-oder Aramidfasern, als Pressmasse mit Kurzfasern/Whiskers und als Klebfilme.

15. Verbindung der Formel III, gemäss Anspruch 2, dadurch gekennzeichnet, dass Y 1,5,5-Trimethylcyclohexylen-1,3 bedeutet.

16. Verfahren zum Herstellen von vernetzten Produkten, welche durch Umsetzung ein (i) Polyimids der Formel (I) mit einer (ii) Verbindung der Formel II wobei die Verbindungen der Formeln (I) und (II) wie in Anspruch 1 definiert sind, durch Erhitzen auf Temperaturen zwischen 50 und 300°C dadurch gekennzeichnet, dass das Reaktionsgemisch ein (iii) Dihydroxybenzol oder ein in 2- und/oder 6-Stellung sterisch gehindertes Phenol oder ein sekundäres aromatisches Amin enthält.